# EUROPÄISCHE PATENTANMELDUNG

(11) **EP 4 002 970 A1**
(43) Veröffentlichungstag der Anmeldung: **25.05.2022**
(21) Anmeldenummer: 21020589.4
(22) Anmeldetag: 23.11.2021
(51) Int. Cl.: H05K 7/20

(54) **ANORDNUNG MIT GEHÄUSE ZUR AUFNAHME EINER WÄRMEABGEBENDEN ELEKTRONISCHEN KOMPONENTE UND MIT KÜHLSYSTEM ZUM KÜHLEN VON DIESER**

(30) Priorität: 23.11.2020 DE 102020007137; 09.11.2021 DE 102021005555
(71) Anmelder: Voss Automotive GmbH, 51688 Wipperfürth (DE)
(72) Erfinder: ENGLERT, Christoph, 51429 Bergisch Gladbach (DE)
(74) Vertreter: Rebbereh, Cornelia

(57) **Zusammenfassung**

Bei einer Anordnung (1) mit Gehäuse (2) zur Aufnahme zumindest einer wärmeabgebenden elektronischen Komponente (6, 6a, 6b), insbesondere Leistungselektronikkomponente, und mit Kühlsystem zum Kühlen der zumindest einen wärmeabgebenden elektronischen Komponente (6, 6a, 6b), wobei die zumindest eine wärmeabgebende elektronische Komponente (6, 6a, 6b) in dem Gehäuse (2) angeordnet ist, und wobei das Kühlsystem zumindest einen Wärmetauscher umfasst, ist der zumindest eine Wärmetauscher ein Flüssigkeitswärmetauscher und ist zumindest ein Profilelement (3) aus zumindest einem wärmeleitenden Material vorgesehen, wobei das zumindest eine Profilelement (3) der Flüssigkeitswärmetauscher ist und zumindest zwei Strömungskanäle (37) zum Durchströmen mit Fluid aufweist, und wobei das zumindest eine Profilelement (3) in dem Gehäuse (2) in einer vorgebbaren Position zu der zumindest einen wärmeabgebenden elektronischen Komponente (6, 6a, 6b) angeordnet ist.

## Beschreibung

Die Erfindung betrifft eine Anordnung mit Gehäuse zur Aufnahme zumindest einer wärmeabgebenden elektronischen Komponente, insbesondere Leistungselektronikkomponente, und mit Kühlsystem zum Kühlen der zumindest einen wärmeabgebenden elektronischen Komponente, wobei die zumindest eine wärmeabgebende elektronische Komponente in dem Gehäuse angeordnet ist, und wobei das Kühlsystem zumindest einen Wärmetauscher umfasst.

Anordnungen mit Gehäuse und Kühlsysteme zum Kühlen wärmeabgebender elektronischer Komponenten sind im Stand der Technik bekannt. Zumeist sind die elektronischen Komponenten in einem Gehäuse integriert, wobei die Kernfunktion des Gehäuses der Schutz der elektronischen Komponenten vor Medien, wie Staub- und Flüssigkeitspartikeln, sowie gegen Stoßbelastungen und gegen zu hohe und zu niedrige Temperaturen ist. In Automotiveanwendungen werden solche Gehäuse zum Erzielen einer ausreichenden Robustheit und EMV-Kompatibilität, also elektromagnetischen Verträglichkeit, teilweise aus Aluminiumdruckguss hergestellt. Für den Fall, dass zumindest ein Teil der elektronischen Komponenten gekühlt werden muss oder sollte, ist es ferner bekannt, das Gehäuse so aufzubauen, dass die Wärmequellen thermischen Kontakt zum Gehäuse haben, das seinerseits von außen, also außerhalb des Gehäuses, vermittels einer oder mehrerer Kühlplatten gekühlt wird. Solche Kühlplatten werden gegebenenfalls von einem Fluid durchströmt, sind also flüssigkeitsgekühlte Kühlplatten.

Aus der DE 10 2018 002 980 A1 ist beispielsweise eine Wärmetauscher-Einheit bekannt, die zumindest ein thermoelektrisches Element, insbesondere ein Peltier-Element, zumindest ein Wärmetauscherelement zum Wärmetausch mit dem thermoelektrischen Element und zumindest ein Verteilerelement zum Zuführen und Abführen eines das zumindest eine Wärmetauscherelement durchströmenden Wärmetauschermediums umfasst, wobei zumindest ein Halterahmen zum Halten des zumindest einen Wärmetauscherelements an dem zumindest einen thermoelektrischen Element vorgesehen ist. Das Verteilerelement ist mit dem Wärmetauscherelement und dem Halterahmen verbunden bzw. kann mit diesen verbunden werden. Bei diesem Aufbau ist allerdings lediglich ein Halterahmen, kein das thermoelektrische Element vollständig umschließendes Gehäuse vorgesehen, so dass sich dieser Aufbau mit dem Halterrahmen bei Umgebungen, bei denen Staub- und Flüssigkeitspartikel vorliegen und dementsprechend sich als problematisch für eine elektronische Komponente auswirken können, nicht eignet.

Aus der EP 3 418 653 A2 ist eine Vorrichtung zum Temperieren eines temperierbaren oder zu temperierenden Volumens, umfassend zumindest eine ein temperierbares Volumen umgrenzende Wandung, bekannt, wobei eine Trennung von Kühl- und Heizfunktion der Vorrichtung zum Temperieren vorgesehen ist. Die zumindest eine Wandung zum Beheizen des zumindest einen temperierbaren oder zu temperierenden Volumens kann beheizt werden. Ferner ist zumindest eine Kühleinrichtung zum Kühlen des temperierbaren Volumens vorgesehen. Die zumindest eine Kühleinrichtung umfasst zumindest ein thermoelektrisches Element und zumindest einen Wärmetauscher zum Abführen von Wärme von dem thermoelektrischen Element. Der Wärmetauscher kann ein Luft-Wärmetauscher oder ein mediumdurchströmter Wärmetauscher sein.

Als weiter nachteilig bei den Lösungen des Standes der Technik, bei denen beispielsweise ein Gehäuse aus Aluminiumdruckguss vorgesehen ist, bei dem eine Kühlung durch Kühlplatten erfolgt, erweist sich das hohe Gewicht des Gehäuses einerseits und der Kühlplatte andererseits als nachteilig. Ebenfalls erweisen sich die hohen Herstellungskosten eines solchen Aluminiumdruckgussgehäuses durch geringe Standzeiten der Aluminiumdruckguss-Werkzeuge als nachteilig. Auch die ineffiziente Kühlung durch einen hohen thermischen Widerstand zwischen der jeweiligen Wärmequelle und dem Kühlmedium erweist sich bei Verwendung der mit Wasser durchströmten Kühlplatte ebenfalls als nachteilig.

Der vorliegenden Erfindung liegt daher die Aufgabe zugrunde, eine Anordnung mit Gehäuse zur Aufnahme zumindest einer wärmeabgebenden elektronischen Komponente, insbesondere Leistungselektronikkomponente, und mit Kühlsystem zum Kühlen der zumindest einen wärmeabgebenden elektronischen Komponente, wobei die zumindest eine wärmeabgebende elektronische Komponente in dem Gehäuse angeordnet ist, und wobei das Kühlsystem zumindest einen Wärmetauscher umfasst, vorzusehen, das die vorstehend genannten Nachteile vermeidet, wobei das Kühlsystem serienfähig, effizient und für Automotiveanwendungen geeignet ist.

Die Aufgabe wird für eine Anordnung nach dem Oberbegriff des Anspruchs 1 dadurch gelöst, dass der zumindest eine Wärmetauscher ein Flüssigkeitswärmetauscher ist und zumindest ein Profilelement aus zumindest einem wärmeleitenden Material vorgesehen ist, wobei das zumindest eine Profilelement der Flüssigkeitswärmetauscher ist und zumindest zwei Strömungskanäle zum Durchströmen mit Fluid aufweist, und wobei das zumindest eine Profilelement in dem Gehäuse in einer vorgebbaren Position zu der zumindest einen wärmeabgebenden elektronischen Komponente angeordnet ist. Weiterbildungen der Erfindung sind in den abhängigen Ansprüchen definiert.

Dadurch wird eine Anordnung mit Gehäuse und Kühlsystem vorgesehen, mit dem zumindest eine wärmeabgebende elektronische Komponente, wie beispielsweise Leistungselektronikkomponente, effizient gekühlt werden kann. Die zumindest eine wärmeabgebende elektronische Komponente ist hierbei in einem Gehäuse angeordnet. Ferner ist in dem Gehäuse zumindest ein Profilelement in einer definierten, also vorgebbaren, Position zu der zumindest einen wärmeabgebenden elektronischen Komponente angeordnet. Zum Schaffen und/oder Einhalten eines solchen definierten Abstands kann zumindest ein Mittel vorgesehen werden, wie z.B. zumindest ein Stegelement und/oder Halteelement. Das zumindest eine Profilelement besteht aus einem wärmeleitenden Material und dient daher dem Ableiten von Wärme von der wärmeabgebenden elektronischen Komponente, wie Leistungselektronikkomponente, nach außerhalb des Gehäuses, um ein Überhitzen der Komponente zu vermeiden. Die von der elektronischen Komponente während deren Betriebs abgegebene Wärme kann somit über das zumindest eine Profilelement aus dem Gehäuse herausgeführt werden. Das Profilelement ist als Flüssigkeitswärmetauscher ausgebildet und zu diesem Zweck mit zumindest zwei inneren Strömungskanälen versehen und wird an zumindest eine Leitung zur Flüssigkeitszu- und -abfuhr, insbesondere Kühlmittelzu- und -abfuhr, angeschlossen. Durch die zumindest zwei Strömungskanäle wird eine Flüssigkeit bzw. ein Fluid, wie Kühlmittel, geleitet und dient dem Abtransport der Wärme nach außen aus dem Gehäuse heraus. Zwischen den zumindest zwei Strömungskanälen und außenseitig benachbart zu diesen ist/sind ein Stegbereich(e) vorgesehen, die die Strömungskanäle voneinander abgrenzen und außenseitig begrenzen. Da in das Gehäuse, das die zumindest eine wärmeabgebende elektronische Komponente umgibt, das zumindest eine Profilelement eingelegt wird, ist der Platzbedarf deutlich geringer als beim Stand der Technik, bei dem außenseitig auf das Gehäuse, das im Inneren die zumindest eine wärmeabgebende elektronische Komponente enthält, eine Kühlplatte aufgebracht ist. Es muss somit beim Einbau des die zumindest eine elektronische Komponente enthaltenden Gehäuses kein weiterer Platzbedarf für das Kühlen der zumindest einen wärmeabgebenden elektronischen Komponente berücksichtigt werden.

Vorteilhaft ist das zumindest eine Profilelement in dem Gehäuse federnd gelagert. Hierdurch ist es möglich, dass das Profilelement in der vorgegebenen Position auch bei Aufbringen einer Druckkraft auf das Profilelement verbleibt, ohne dass sich das Profilelement in Längsrichtung, also in seiner Extrusionsrichtung, verschiebt. Hierbei kann eine minimale Verschiebung in Längsrichtung des Profilelementes gegebenenfalls zugelassen werden. Durch das Vorsehen einer federnden Lagerung bzw. zumindest eines Federelements oder elastischen Elements, über das das Profilelement entlang seiner Längsseiten gelagert ist, kann eine Längenausdehnung des Profilelements problemlos ausgeglichen bzw. abgefangen werden, ohne dass der definierte Abstand zu der zumindest einen wärmeabgebenden elektronischen Komponente unterschritten würde. Das zumindest eine Federelement oder elastische Element kann beispielsweise in seitlich, entlang den Seitenrädern des Profilelements angeordnete Nuten oder Aussparungen eingreifen. Z.B. können diese etwa in der Mitte bzw. Hälfte in Längserstreckungsrichtung des Profilelements angeordnet sein oder werden. Anstelle zumindest von einem Federelement oder elastischen Element können auch andere Steg- bzw. Haltelemente vorgesehen werden, die in entsprechende Nuten oder Aussparungen entlang der Seitenränder des Profilelements eingreifen und dieses dementsprechend in Längsrichtung in der gewünschten Position halten können. Auch Fertigungstoleranzen bezüglich des Profilelements und des Gehäuses können ausgeglichen werden. Zu diesem Zweck können die bereits erwähnten Mittel zum Schaffen und/oder Einhalten eines definierten Abstands zwischen Profilelement und der zumindest einen wärmeabgebenden elektronischen Komponente vorgesehen werden. Gerade bei Auftreten solcher Fertigungstoleranzen wäre es ansonsten schwierig, einen vorgegebenen Abstand zwischen Profilelement und der zumindest einen wärmeabgebenden elektronischen Komponente einzuhalten, da insbesondere bei Gut-Toleranzen bei Längenausdehnung des Profilelements dieses sich wölben kann. Dies führt dazu, dass die Wölbung in Richtung der zumindest einen wärmeabgebenden elektronischen Komponente und auch weg von dieser erfolgen kann. Bei einem Wölben in Richtung der zumindest einen wärmeabgebenden elektronischen Komponente wird selbstverständlich der gewünschte vorgegebene bzw. definierte Abstand zu dieser nicht mehr eingehalten, so dass durch Vorsehen eines entsprechend ein solches Wölben verhindernden Mittels die Einhaltung des gewünschten Abstands zur zumindest einen wärmeabgebenden elektronischen Komponente erzielt werden kann. Das Profilelement kann in dem Gehäuse durch Klemmen vormontiert werden. Hierzu können beispielsweise ein oder mehrere Klemmvorrichtungen, insbesondere Stegelemente bzw. Auflageelemente auf einer Außenseite des Profilelements, beispielsweise der Unterseite des Profilelements, mit seitlichen Klemmeinrichtungen kombiniert werden. Diese können sich beispielsweise in Seitenwandungen des Profilelements eindrücken, um dieses klemmend in Position zu halten. Es ist somit einerseits möglich, das Profilelement bereits entlang seiner Seitenränder mit zumindest einer Nut oder Aussparung zu versehen, in die ein Fixier- oder Haltelemente, das insbesondere am Gehäuse angeordnet ist, eingreifen und somit das Profilelement auch bei Längenausdehnung fixieren kann. Oder es kann zumindest eine Klemmeinrichtung seitlich entlang den Seiten- bzw. Längsrändern des Profilelements an diesem angreifen und sich zumindest leicht in diese eindrücken, so dass hierüber ein klemmender Halt und Fixierung des Profilelements im Gehäuse ermöglicht werden kann. Beispielsweise können zumindest zwei Fixierelemente an den beiden einander gegenüberliegenden Längsseiten des Profilelements vorgesehen werden und an diesem angreifen. Es kann zumindest eine Einkerbung oder Prägung entlang der Längsseiten des Profilelements vorgesehen werden, insbesondere etwa im Bereich der halben Länge des Profilelements, wobei diese vorteilhaft mitten im Gehäuse bzw. in der Gehäusemitte angeordnet wird. Bei einem solchen Einkerben oder Prägen des Profilelements kann vorteilhaft vorgesehen sein, dass die jeweiligen im äußeren Randbereich des Profilelements angeordneten Strömungskanäle in diesem durch das Einkerben oder Prägen deformiert werden, hierdurch sich jedoch der verfügbare Strömungsquerschnitt des Profilelements nicht verändert, sofern diese randseitigen Strömungskanäle ohnehin endseitig durch Vorsehen zumindest einer Abdichtung bzw. zumindest eines Dichtelements zumindest teilweise oder vollständig verschlossen sind.

Wird das Profilelement klemmend zwischen einer Vormontage-Klemmeinrichtung und Fixierelementen angeordnet, die auf einander gegenüberliegenden Seiten des Profilelements an diesem angreifen, können die Fixierelemente stiftförmig ausgebildet werden, während die Auflagefläche zum Auflagern des Profilelementes beispielsweise abgerundet ausgebildet sein kann. Die Fixierelemente können sich insbesondere von der Oberseite des Profilelements aus in dieses zum Toleranzausgleich eindrücken, insbesondere dann, wenn für das Profilelement ein weiches Material, wie beispielsweise Aluminium, verwendet wird. Die Eindringtiefe der Fixierelemente kann beispielsweise dahingehend vorgegeben werden, dass die verringerte lichte Höhe des inneren Strömungskanals des Profilelements durch das Eindrücken um maximal 50 %, insbesondere maximal 40 %, maximal 30 %, maximal 20 % oder maximal 10 %, verringert wird. Als weiter vorteilhaft erweist es sich, wenn die Fixierelemente in Bereichen des Profilelementes angreifen, an denen die inneren Strömungskanäle verlaufen, um die diesen benachbarten Stegbereiche einerseits nicht zu beschädigen und andererseits durch diese Stegbereiche nicht am Toleranzausgleich gehindert zu werden. Daher können weiter vorteilhaft unterschiedlich breite innere Strömungskanäle im Profilelement vorgesehen werden oder die Lage bzw. Positionierung der Fixierelemente im Vergleich zum Profilelement kann entsprechend dahingehend vorgenommen bzw. eingestellt werden, dass die Fixierelemente nicht auf den Stegbereichen zur Auflage kommen.

Die Auflagefläche der Fixierelemente kann beispielsweise kleiner als die Auflagefläche der Vormontage-Klemmeinrichtung gewählt werden, um sicherzustellen, dass sich die Fixierelemente in das Profilelement eindrücken und nicht umgekehrt die Vormontage-Klemmeinrichtung sich in die Fläche des Profilelements eindrückt. Ferner ist es möglich, die Fixierelemente aus einem elastischen Material, wie einem Elastomer, auszubilden. Beispielsweise kann das Gehäuse im Bereich der Fixierelemente aus einem Zweikomponentenmaterial bestehen, so dass der Bereich der Fixierelemente aus einem entsprechenden elastischen Material oder Elastomer ausgebildet ist. Ebenfalls ist es möglich, zum Ausbilden der Fixierelemente in dem Gehäuse entsprechende Einsätze aus elastischem bzw. Elastomermaterial vorzusehen.

Als weiter vorteilhaft erweist es sich, zumindest zwei Fixierelemente entlang der Längserstreckung bzw. der Längsseiten des Profilelements anzuordnen. Durch das Vorsehen der Fixierelemente, die in das Profilelement eindringen, kann das Profilelement auch gegen ein Verschieben in Längsrichtung von diesem fixiert werden. Beispielsweise ist es möglich, lediglich auf einer Längsseite des Profilelements Fixierelemente vorzusehen, die in dieses eindringen, während auf der anderen bzw. gegenüberliegenden Seite des Profilelements Fixierelemente aus Elastomermaterial vorgesehen werden.

Vorteilhaft ist das zumindest eine Profilelement gegenüber einem Eindringen von Medien in das Innere des Gehäuses abgedichtet aus dem Gehäuse so herausgeführt, dass ein Bewegen des Profilelements in Richtung der wärmeabgebenden elektronischen Komponente ermöglicht wird. Wird somit eine Druckkraft auf das Profilelement aufgebracht, um dieses näher an die zumindest eine wärmeabgebende elektronische Komponente heranzubringen und hierdurch den thermischen Widerstand zu verringern, wird hierdurch die Abdichtung nicht unwirksam. Die Abdichtung bzw. das zumindest eine Dichtelement ist so konfiguriert, dass ein Bewegen des zumindest einen Profilelements auch im Bereich seiner Herausführung aus dem Gehäuse möglich ist. Die Abdichtung bzw. das zumindest eine Dichtelement ist somit so nachgiebig und rückstellend ausgebildet, dass es bei einem Bewegen des Profilelements an diesem anliegend verbleibt und somit seine Dichtwirkung auch bei leichtem Auslenken des Profilelements aufrechterhält.

Weiter vorteilhaft ist das zumindest eine Profilelement endseitig in Anschlussverbindern zum Anschließen zumindest einer Leitung zur Flüssigkeitskühlung gegenüber dem Inneren des Gehäuses abgedichtet aufgenommen.

Um einem auf das zumindest eine aus dem Gehäuse herausgeführte Profilelement durch zumindest ein dort vorgesehenes Dichtelement ausgeübten Druck standhalten zu können, kann die Anzahl der inneren Strömungskanäle und von zwischen diesen angeordneten Stegbereichen des zumindest einen Profilelements in Abhängigkeit von dessen Höhenstabilität variiert bzw. entsprechend gewählt werden. Das zumindest eine Dichtelement drückt im Bereich der abgedichteten Herausführung des Profilelements aus dem Gehäuse auf das Profilelement. Da das Profilelement im Innern eine Anzahl von Strömungskanälen und zwischen diesen angeordneten Stegbereichen aufweist, kann ein auf das Profilelement ausgeübter Druck durch die Stegbereiche aufgenommen werden. Die Dichtelemente üben einen solchen Druck gegen die Außenseiten des Profilelements aus, um dieses sicher gegen ein Eindringen von Medien in das Innere des Gehäuses abdichten zu können. Daher erweist es sich im Hinblick auf die Höhenstabilität des Profilelements, also dessen Stabilität in Höhenerstreckungsrichtung, zum Vermeiden eines Eindrückens von diesem, als vorteilhaft, das Verhältnis der Anzahl und des Durchmessers bzw. der Abmessungen von Strömungskanälen und Stegbereichen im Innern des Profilelements so zu wählen, dass die Druckstabilität der Stegbereiche und somit des Profilelements erhalten bleibt, um dem auf das Profilelement in dessen Höhenrichtung ausgeübten Druck standhalten zu können. Dies kann insbesondere bei einer großen Anzahl von Stegbereichen und dazwischen angeordneten Strömungskanälen erreicht werden.

Als weiter vorteilhaft erweist es sich, wenn das zumindest eine Profilelement zumindest doppelt so breit wie hoch ist, insbesondere die Breitenerstreckung des zumindest einen Profilelements x-mal so groß wie dessen Höhenerstreckung ist, wobei x eine natürliche oder rationale Zahl größer 2 ist, z.B. 3, 4, 5, 6, 7 oder 6 2/3 etc. Hierdurch kann ebenfalls eine ausreichende Stabilität des Profilelements vorgesehen werden.

Das zumindest eine Profilelement ist vorteilhaft als Aluminiumprofil, insbesondere Aluminiumextrusionsprofil ausgebildet. Durch die Ausbildung als Flüssigkeitswärmetauscher ist dabei eine gute Kühlung auch bei geringen Volumenströmen möglich aufgrund vorteilhaft vorgesehener sehr geringer Wandstärke des Profilelements und großer zur Wärmeübertragung zur Verfügung stehender Oberfläche.

Weiter vorteilhaft kann zur weiteren Verbesserung des Wärmeübergangs das zumindest eine Profilelement auf zumindest einer nicht zur Wärmeübertragung dienenden Außenseite zumindest ein oberflächenvergrößerndes Element, insbesondere Einkerbungen, Nuten oder andere flächenvergrößernde Elemente und/oder in das Innere des Profilelements hineinragende Elemente, aufweisen. Auch hierdurch ist eine Vergrößerung der wärmeübertragenden Fläche des zumindest einen Profilelementes möglich, wobei zugleich die Strömung in dem zumindest einen Strömungskanal im Innern des zumindest einen Profilelements durch die zumindest eine Einkerbung, Nut oder das zumindest eine andere in den zumindest einen Strömungskanal hineinragende flächenvergrößernde Element stärker verwirbelt wird. Trotz des Aufbringens des zumindest einen oberflächenvergrößernden Elements auf der nicht der Wärmeübertragung dienenden Außenseite des zumindest einen Profilelements kann hierdurch die wärmeübertragende Fläche vergrößert werden, da die zumindest eine wärmeabgebende elektronische Komponente ihre Wärme ins gesamte Innere des Gehäuses hinein abgibt, somit das Profilelement über seine gesamte Oberfläche hinweg, also auch auf der der zumindest einen wärmeabgebenden elektronischen Komponente abgewandten Außenseite Wärme aufnehmen kann.

Durch die definierte bzw. exakte, vorgebbare Positionierung des zumindest einen Profilelementes im Gehäuse, in dem auch die zumindest eine wärmeabgebende elektronische Komponente angeordnet ist, kann auch der thermische Widerstand reduziert werden, da das zumindest eine Profilelement direkt benachbart zu der zumindest einen wärmeabgebenden elektronischen Komponente angeordnet werden kann. Es ist somit ein geringer Abstand zur Wärmequelle, nämlich der zumindest einen wärmeabgebenden elektronischen Komponente, möglich.

Weiter vorteilhaft kann das zumindest eine Profilelement an der zumindest einen wärmeabgebenden elektronischen Komponente anliegend angeordnet sein, wobei durch das zumindest eine Profilelement ein Anpressdruck gegen die zumindest eine wärmeabgebende elektronische Komponente ausgeübt wird bzw. werden kann. Hierdurch ist eine weitere Reduzierung des thermischen Widerstands möglich, da das zumindest eine Profilelement direkt an der Wärmequelle in Form der zumindest einen wärmeabgebenden elektronischen Komponente anliegt. Ferner ist es möglich, zumindest einen Abstandshalter im Bereich der zumindest einen wärmeabgebenden elektronischen Komponente vorzusehen. Das zumindest eine Profilelement kann dabei so an dem zumindest im Bereich der zumindest einen wärmeabgebenden elektronischen Komponente angeordneten oder einen Abstand zu dieser bzw. diesen schaffenden Abstandshalter anliegend oder an diesen/diesem angreifend angeordnet sein, dass durch das zumindest eine Profilelement ein Anpressdruck gegen den zumindest einen Abstandshalter ausgeübt wird. Auch hierüber kann ein geringer Abstand zwischen dem zumindest einen Profilelement und der Wärmequelle in Form der zumindest einen wärmeabgebenden elektronischen Komponente geschaffen werden, wobei zugleich das Ausüben einer Druckkraft auf die Wärmequelle, also die zumindest eine wärmeabgebende elektronische Komponente vermieden wird. Gerade bei druckempfindlichen elektronischen Komponenten und auch bei Vorsehen von Lötstellen, über die die zumindest eine elektronische Komponente auf einer Platine aufgebracht ist, erweist sich dies als sehr vorteilhaft, um weder die elektronische Komponente noch die Lötstellen zu beschädigen.

Sind im Innern des Gehäuses mehrere Wärmequellen in Form von mehreren wärmeabgebenden elektronischen Komponenten angeordnet, kann das zumindest eine Profilelement zur konturnahen Kühlung der wärmeabgebenden elektronischen Komponente vorteilhaft gebogen, gekröpft, konturiert oder anderweitig dreidimensional aus einer ebenen Erstreckung abweichend ausgebildet werden. Die Biegung oder dreidimensionale Ausformung ist dabei so vorgesehen, dass einerseits unterschiedliche Höhenlagen der wärmeabgebenden elektronischen Komponente hierdurch ausgeglichen werden, somit eine konturnahe Anordnung des zumindest einen Profilelements an den in unterschiedlichen Höhen angeordneten oder unterschiedliche Höhen aufweisenden wärmeabgebenden elektronischen Komponenten möglich ist, und andererseits eine Anpassung an deren Kontur ermöglicht wird, was ebenfalls durch ein gebogenes, insbesondere mehrfach gebogenes Profilelement, das daran angepasst ausgebildet/geformt ist, erfolgen kann. Durch das Vorsehen eines entsprechend gebogenen Profilelementes ist somit eine konturnahe Kühlung und somit ein geringer thermischer Widerstand zum Erzielen einer effizienten Kühlung der zumindest einen wärmeabgebenden elektronischen Komponente möglich.

Weiter vorteilhaft kann eine zweifache Abdichtung der Profilelementenden vorgesehen sein, wobei zumindest ein erstes Dichtelement zur Flüssigkeitsabdichtung gegenüber den Anschlussverbindern, mittels derer das zumindest eine Profilelement an zumindest einer Leitung zur Flüssigkeitszu- und -abfuhr angeschlossen wird, und zumindest ein zweites Dichtelement zur Flüssigkeitsabdichtung gegenüber von außen in das Gehäuse eindringenden Medien und zum zusätzlichen Schutz der im Gehäuse angeordneten zumindest einen wärmeabgebenden elektronischen Komponente vorgesehen sind. Über das zumindest eine erste Dichtelement ist somit ein Abdichten im Bereich der Anschlussverbinder möglich, so dass der Fluidpfad nach außen abgedichtet wird. Das zumindest eine erste Dichtelement soll eine Leckage von insbesondere Kühlmittel aus den Anschlussverbindern nach außen vermeiden. Das zumindest eine zweite Dichtelement ist im Bereich des Gehäuses insbesondere auf dessen Außenseite so positioniert, dass ein Eindringen von Flüssigkeit und anderen Medien von außen in das Gehäuse hinein sicher vermieden werden kann. Das zumindest eine zweite Dichtelement dient somit dem zusätzlichen Schutz der zumindest einen im Innern des Gehäuses angeordneten wärmeabgebenden elektronischen Komponente. Es dient insbesondere auch in Falle einer Leckage im Bereich des zumindest einen ersten Dichtelements zur weiteren Flüssigkeitsabdichtung zum Verhindern eines Eindringens von Kühlmittel bzw. von Flüssigkeit in das Innere des Gehäuses und zu der darin angeordneten zumindest einen wärmeabgebenden elektronischen Komponente.

Das Gehäuse ist vorteilhaft ein Kunststoffgehäuse, insbesondere ein spritzgegossenes Kunststoffgehäuse. Hierdurch kann das Gewicht des Gehäuses gegenüber den Gehäusen aus Aluminiumdruckguss des Standes der Technik deutlich reduziert werden, ebenso wie die Herstellungskosten für ein solches insbesondere spritzgegossenes Kunststoffgehäuse gegenüber dem Aluminiumdruckgussgehäuse des Standes der Technik. Um eine elektromagnetische Verträglichkeit bzw. EMV-Kompatibilität des Gehäuses vorzusehen, ist es ferner möglich, das Gehäuse zumindest teilweise leitfähig auszubilden, z.B. zu dotieren, insbesondere ein zumindest teilweise leitfähig dotiertes Kunststoffgehäuse vorzusehen.

Weiter vorteilhaft ist das Gehäuse mehrteilig, insbesondere zweiteilig, ausgebildet und die Gehäuseteile mediumdicht, insbesondere stoffschlüssig, miteinander verbunden. Beispielsweise kann eine solche dichte stoffschlüssige Verbindung durch Verschweißen erfolgen. Ein solches dichtes Verschweißen der zumindest zwei Gehäuseteile kann den Einbau einer umlaufenden Dichtung ersparen, was ebenfalls zu einer Kostenreduzierung einerseits aufgrund Einsparens der Dichtung und andererseits aufgrund einer schnelleren und einfacheren Montage führt. Auch die Anschlussverbinder zum Anschluss des zumindest einen Profilelementes an zumindest eine Leitung zur Flüssigkeitszu- und -abfuhr, insbesondere Kühlmittelzu- und -abfuhr, können vorteilhaft stoffschlüssig mit dem Gehäuse verbunden, insbesondere mit diesem verschweißt werden oder sein. Hierdurch ist eine zusätzliche Abdichtung gegenüber dem Eindringen von Medien, wie Staub und Flüssigkeit, von außen in das Innere des Gehäuses möglich.

Das zumindest eine Profilelement wird endseitig aus dem Gehäuse herausgeführt. Die Profilelementenden können dabei etwa in der Ebene des Profilelementkörpers angeordnet sein und aus dem Gehäuse in dieser Erstreckung herausgeführt werden, sich somit das gesamte Profilelement mit seinem Profilelementkörper und seinen Profilelementenden etwa in einer Ebene erstrecken. Ebenfalls ist es möglich, dass das Profilelement endseitig abgewinkelt ist. Insbesondere können die Profilelementenden etwa rechtwinklig zur Erstreckung des übrigen Profilelementkörpers angeordnet sein. Durch ein solches endseitiges Abwinkeln des zumindest einen Profilelementes, was sich beispielsweise vom Stand der Technik der DE 10 2018 002 980 A1 unterscheidet, ist ein Einbau zumindest eines Profilelementes in Montagerichtung und Entformungsrichtung des spritzgegossenen Gehäuses möglich, insbesondere in einen der Gehäuseteile, vorteilhaft den Gehäuseteil, in den nicht die zumindest eine wärmeabgebende elektronische Komponente eingebaut wird. Der Einbau und die exakte Positionierung des zumindest einen Profilelements sind hierdurch somit mühelos möglich. Durch eine solche Formgebung ist ferner das gewünschte federnde Lagern des Profilelements im Gehäuse einerseits und andererseits eine sichere und problemlose Aufnahme der Profilelementenden in den Anschlussverbindern, die dem Anschluss an zumindest eine Leitung zur Flüssigkeits- bzw. Kühlmittelzu- und -abfuhr dienen, möglich. Auch ein problemloses Abdichten der Profilelementenden im Bereich der Anschlussverbinder ist hierdurch einfacher möglich, da auch bei Druckaufbringung auf das Profilelement im Bereich der abgewinkelten Profilelementenden quer zur Längserstreckung des Profilelementkörpers, im Wesentlichen in Längsrichtung der Profilelementenden keine oder zumindest kaum eine Bewegung erfolgt.

Alle Komponenten, also das Gehäuse bzw. dessen Gehäuseteile, das zumindest eine Profilelement, die zumindest eine wärmeabgebende elektronische Komponente, Dichtelemente und Anschlussverbinder können somit vorteilhaft sequentiell in einer Montagerichtung gefügt und positioniert werden. Hierdurch kann eine prozesssichere Serienfertigung sichergestellt werden.

Das zumindest eine Profilelement kann entweder an ein separates Kühlsystem über den zumindest einen Anschlussverbinder angeschlossen werden, was einen Schutz vor Ablagerungen in den Strömungskanälen des zumindest einen Profilelementes ermöglicht, oder, bei Anwendungen im Automotive- bzw. Fahrzeugbereich, an ein Kühlsystem eines Fahrzeugs, wie beispielsweise eine Klimaanlage. Im letzteren Falle kann vorteilhaft zumindest ein Filterelement im Bereich vor dem Eintritt des Kühlmittels in die Anordnung bzw. deren Profilelement vorgesehen werden, um den Eintrag von Schwebstoffen, die zu Ablagerungen in dessen Strömungskanälen und einem sich hieraus ergebenden Zusetzen von diesen führen können, zu vermeiden.

Zur näheren Erläuterung der Erfindung werden im Folgenden Ausführungsbeispiele von dieser näher anhand der Zeichnungen beschrieben. Diese zeigen in:
- Figur 1: eine perspektivische Explosionsansicht einer erfindungsgemäßen Anordnung mit zweiteiligem Gehäuse und erfindungsgemäßem Kühlsystem zum Kühlen einer in das Gehäuse aufzunehmenden wärmeabgebenden elektronischen Komponente,
- Figur 2: eine perspektivische Ansicht der Anordnung mit Gehäuse und Kühlsystem gemäß Figur 1 in gegenüber dieser um 180° gedrehter Positionierung, wobei die Anordnung hierbei von oben nach unten in Montagerichtung gezeigt ist,
- Figur 3: eine Detailschnittansicht der Anordnung mit Gehäuse und Kühlsystem gemäß Figur 1 im zusammengesetzten und innerhalb des Gehäuses mit einer elektronischen Komponente versehenen Zustand,
- Figur 4: eine Detailschnittansicht der Anordnung mit Gehäuse und Kühlsystem gemäß Figur 3 im Bereich des aus dem Gehäuse herausgeführten, federnd gelagerten erfindungsgemäßen Profilelements,
- Figur 5: eine Detailschnittansicht einer Ausführungsform einer erfindungsgemäßen doppelten Abdichtung eines erfindungsgemäßen Profilelements im Bereich von dessen Herausführung aus dem Gehäuse, überdeckt von einem Anschlussverbinder zum Anschließen an ein Flüssigkeitskühlsystem, wobei zwei Dichtelemente und ein dazwischen angeordneter Stützring zum Abdichten vorgesehen sind,
- Figur 6: eine Detailschnittansicht einer zweiten Ausführungsform einer erfindungsgemäßen Anordnung aus Gehäuse und darin integriertem erfindungsgemäßen Profilelement eines erfindungsgemäßen Kühlsystems zum Kühlen einer elektronischen Komponente im Innern des Gehäuses, wobei das Profilelement an der wärmeabgebenden elektronischen Komponente anliegt,
- Figur 7: eine Detailschnittansicht einer dritten Ausführungsform einer erfindungsgemäßen Anordnung mit Gehäuse und erfindungsgemäßem Profilelement eines erfindungsgemäßen Kühlsystems, wobei im Innern des Gehäuses eine wärmeabgebende elektronische Komponente und benachbart zu dieser Abstandshalter angeordnet sind, wobei das Profilelement an den Abstandshaltern anliegt,
- Figur 8: eine Detailschnittansicht einer vierten Ausführungsform einer erfindungsgemäßen Anordnung mit Gehäuse und darin angeordnetem Profilelement eines erfindungsgemäßen Kühlsystems zum Kühlen einer im Innern des Gehäuses angeordneten wärmeabgebenden elektronischen Komponente, wobei das Profilelement auf seiner der wärmeabgebenden elektronischen Komponente abgewandten Seite mit Einkerbungen zur Oberflächenvergrößerung versehen ist,
- Figur 9: eine Detailschnittansicht einer fünften Ausführungsform einer erfindungsgemäßen Anordnung mit Gehäuse und einem erfindungsgemäßen darin angeordneten Profilelement eines erfindungsgemäßen Kühlsystems zum Kühlen zweier innerhalb des Gehäuses angeordneter wärmeabgebender elektronischer Komponenten, wobei das Profilelement gebogen bzw. gekröpft ausgebildet ist, angepasst an die unterschiedlichen Anordnungshöhen der beiden wärmeabgebenden elektronischen Komponenten im Innern des Gehäuses, anliegend an diesen,
- Figur 10: eine perspektivische Ansicht des fertig montierten Gehäuses gemäß Figur 1 und 2 im Bereich eines der beiden an diesem angeordneten Anschlussverbinder zum Anschließen des Profilelements an eine Leitung zum Zu- und Abführen von Kühlmittel,
- Figur 11: eine Detailschnittansicht einer weiteren Ausführungsform einer erfindungsgemäßen Anordnung im Bereich des aus dem Gehäuse herausgeführten, federnd gelagerten erfindungsgemäßen Profilelements, das hier in der Ebene des Profilelementkörpers aus dem Gehäuse herausgeführt ist,
- Figur 12: eine Detailschnittansicht einer erfindungsgemäßen Anordnung im Bereich einer Fixierung des erfindungsgemäßen Profilelements am Gehäuse,
- Figur 13: eine Detailschnittansicht einer weiteren Ausführungsform einer erfindungsgemäßen Anordnung im Bereich einer Fixierung des erfindungsgemäßen Profilelements im Gehäuse, wobei das Profilelement entlang seiner Längserstreckung einerseits und durch Eingreifen zweier Fixierelemente in einer um 90° hierzu stehenden Richtung andererseits fixiert ist, und
- Figur 14: eine skizzenhafte Draufsicht auf ein erfindungsgemäßes Profilelement im Bereich einer Vormontagehalterung zum klemmenden seitlichen Halten des Profilelements im Gehäuse einer erfindungsgemäßen Anordnung.

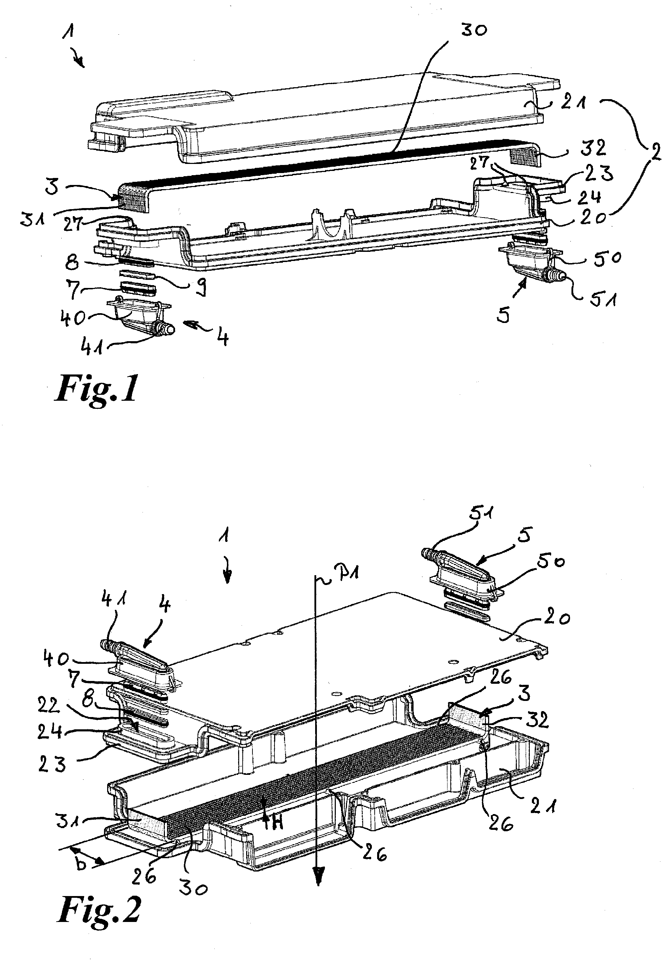

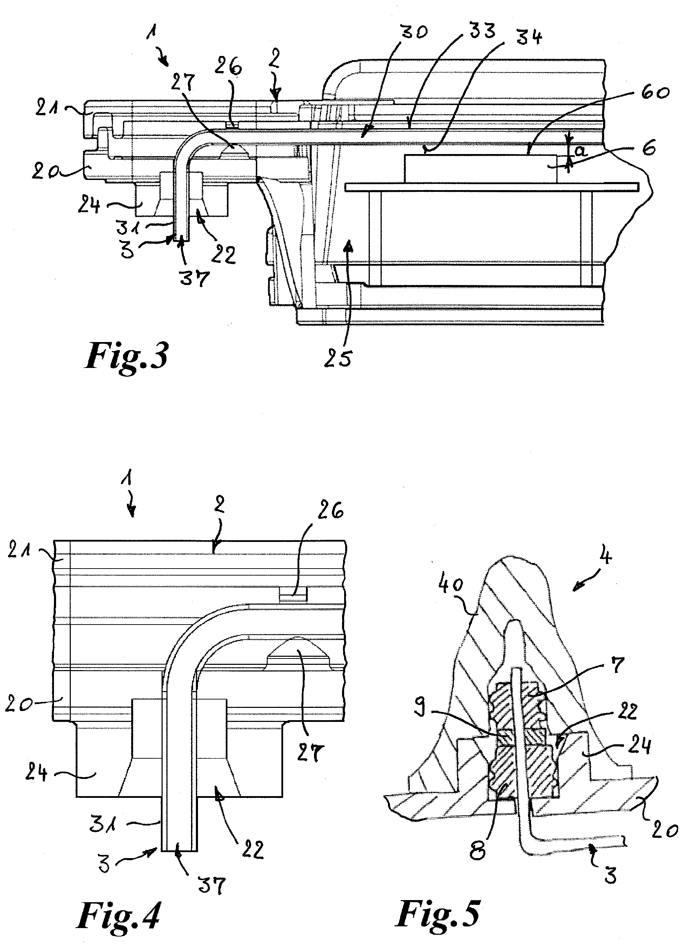

In den Figuren 1 und 2 sind jeweils perspektivische Explosionsansichten einer Anordnung 1 gezeigt, die ein zweiteiliges Gehäuse 2 mit einem ersten Gehäuseteil 20 in Form einer Grundplatte und einem zweiten Gehäuseteil 21 in Form eines Gehäusedeckels umfasst. Ferner umfasst die Anordnung 1 ein Kühlsystem mit einem Flüssigkeitswärmetauscher in Form eines Profilelements 3. Dieses weist einen länglichen Profilelementkörper 30 und zwei Profilelementenden 31, 32, die jeweils an den aneinander gegenüberliegenden Enden des Profilelementkörpers 30 etwa rechtwinklig von diesem abgewinkelt oder abgebogen angeordnet sind, auf. Ferner weist das Profilelement 3 eine Anzahl von inneren Strömungskanälen 37 und zwischen diesen angeordneten Stegbereichen auf. Durch die inneren Strömungskanäle 37 kann Fluid strömen. Die Anordnung 1 umfasst ferner zwei Anschlussverbinder 4, 5. Die Anschlussverbinder 4, 5 können jeweils mit Leitungen bzw. einem Leitungssystem verbunden werden, um eine Zufuhr und Abfuhr von Flüssigkeit zur Flüssigkeitskühlung, insbesondere zum Zu- und Abführen von Kühlmittel zu und vom Profilelement 3, vorzusehen. Das Kühlsystem zum Kühlen einer in dem Gehäuse 2 anzuordnenden elektronischen Komponente 6, wie sie beispielsweise in Figur 3 skizziert ist, beispielsweise einer Leistungselektronikkomponente, umfasst somit das kühlmitteldurchströmbare Profilelement 3 als Flüssigkeitswärmetauscher.

In Figur 2 ist die Montagerichtung der Anordnung 1 durch einen Pfeil P1 angedeutet. Demgemäß wird das Profilelement 3 in den zweiten Gehäuseteil 21, somit den Gehäusedeckel, eingefügt und die zumindest eine wärmeabgebende elektronische Komponente 6, wie beispielsweise eine Leistungselektronikkomponente, inklusive eventuell vorgesehener Platine, auf der diese angeordnet ist, in dem ersten Gehäuseteil 20, also der Grundplatte, montiert. Nachfolgend wird der erste Gehäuseteil 20 auf den zweiten Gehäuseteil 21 aufgefügt, wie in Figur 2 angedeutet. Die beiden Profilelementenden 31, 32 werden dabei durch längliche Öffnungen 22 in laschenförmigen endseitig vorkragenden Abschnitten 23 des ersten Gehäuseteils 20 hindurchgeführt und von den Anschlussverbindern 4, 5 überdeckt bzw. in diesen aufgenommen. Dies kann insbesondere Figur 5 entnommen werden.

Die Öffnung 22 ist mit einem umlaufenden vorkragenden Rand 24 versehen. Dieser wird von einem entsprechend gegengleich geformten Körperabschnitt 40 bzw. 50 des jeweiligen Anschlussverbinders 4, 5 dicht umschlossen. Auch dies kann insbesondere Figur 5 entnommen werden. Wie dieser Figur sowie den Explosionszeichnungen in den Figuren 1 und 2 ebenfalls entnommen werden kann, ist eine doppelte Abdichtung des jeweiligen Profilelementendes 31 bzw. 32 in der Öffnung 22 des ersten Gehäuseteils 20 und den beiden Anschlussverbindern 4, 5 vorgesehen. Ein erstes Dichtelement 7 ist endseitig über das Ende des jeweiligen Profilelementendes 31, 32 gefügt, um eine Flüssigkeitsabdichtung bzw. Kühlmittelabdichtung zwischen den Anschlussverbindern und dem Profilelement 3 vorzusehen zum Verhindern eines Eintritts von Kühlflüssigkeit bzw. Kühlmedium in das Innere 25 des Gehäuses 3. Es wird über dieses erste Dichtelement 7 somit der Fluidpfad in den jeweiligen Anschlussverbinder 4 bzw. 5 hinein nach außen abgedichtet.

Das zweite Dichtelement 8 dient zum Abdichten gegenüber einem Eindringen von Flüssigkeit oder anderen Medien von außen in das Gehäuseinnere 25 und dementsprechend zu der wärmeabgebenden elektronischen Komponente 6 im Innern des Gehäuses 2. Zu diesem Zweck ist das zweite Dichtelement 8 vorgesehen, umgeben von dem umlaufenden vorkragenden Rand 24, der die schmale längliche schlitzförmige Öffnung 22 umgibt, wie in Figur 5 angedeutet. Das Profilelement 3 erstreckt sich durch beide Dichtelemente 7, 8 hindurch, wobei das zweite Dichtelement 8 zwischen Profilelement 3 und umlaufendem vorkragenden Rand 24 angeordnet ist. Zwischen den beiden Dichtelementen 7, 8 kann, wie in Figur 5 ebenfalls zu sehen, ein Stützelement 9 oder Distanzring vorgesehen werden, um die beiden Dichtelemente 7, 8 voneinander beabstandet zu halten und eine kompakte Abdichtung über das jeweilige Profilelementende 30 bzw. 31 hinweg vorzusehen. Grundsätzlich ist es auch möglich, das Stützelement 9 wegzulassen, wenn die Längenverhältnisse bzw. Abmessungen im Bereich der Profilelementenden 31 bzw. 32 im Vergleich zur Bauhöhe des umlaufenden vorkragenden Randes 24 und den Innenabmessungen in den jeweiligen Anschlussverbindern 4 bzw. 5 entsprechend gering sind, so dass das Zwischenfügen des Stützelements 9 oder Distanzrings zwischen die beiden Dichtelemente 7, 8 nicht erforderlich erscheint.

Durch das Vorsehen der beiden Dichtelemente 7, 8 und das Hindurchführen der Profilelementenden 31, 32 durch die schlitzförmigen Öffnungen 22 in den laschenförmigen endseitig vorkragenden Abschnitten 23 des ersten Gehäuseteils 20 ist eine gewisse axiale Beweglichkeit des Profilelementes 3 in Längsrichtung seiner Profilelementenden 31, 32 grundsätzlich gegeben. Durch die beiden Dichtelemente 7, 8 wird dabei eine vollständige Abdichtung gegenüber dem Eindringen von Flüssigkeit oder anderen Medien in das Innere 25 des Gehäuses 2 sichergestellt.

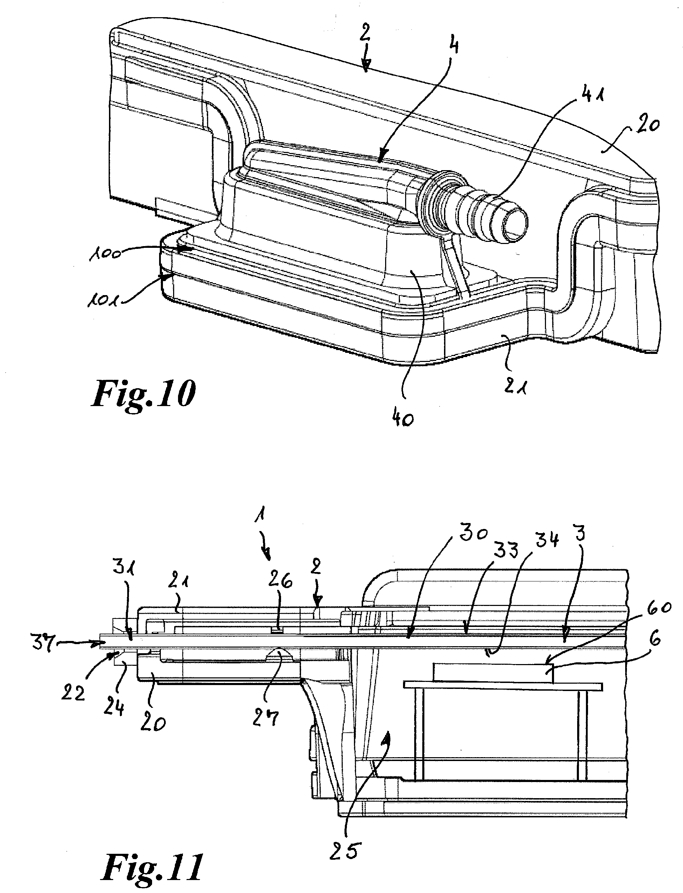

Auch bei einem Ausbilden des Profilelements 3 als langgestrecktes, etwa in einer Ebene ausgebildetes Profilelement 3, bei dem die Profilelementenden 31, 32 sich etwa in derselben Ebene wie der Profilelementkörper 30 erstrecken, wie dies in Figur 11 gezeigt ist, kann eine gewisse Beweglichkeit des Profilelementes 3 quer zu seiner Längserstreckung vorgesehen werden. Durch das Vorsehen der beiden Dichtelemente 7, 8 kann auch hierbei eine vollständige Abdichtung gegenüber dem Eindringen von Flüssigkeit oder anderen Medien in das Innere 25 des Gehäuses 2 sichergestellt werden. Durch geeignetes Konfigurieren der Dichtelemente 7, 8 kann eine Beweglichkeit des Profilelements 3 etwa senkrecht zu dessen Erstreckungsebene zugelassen werden, um das Profilelement 3 zum Verringern des thermischen Widerstands leicht in Richtung zu der wärmeabgebenden elektronischen Komponente 6 bewegen bzw. drücken zu können, wie dies weiter unten noch erläutert wird. Es kann somit Spiel in dieser Richtung vorgesehen werden, um ein geringfügiges Bewegen des Profilelements bei gleichzeitigem Aufrechterhalten der vollständigen Abdichtung zu ermöglichen.

Um das Eindringen von Flüssigkeit und anderen Medien in das Innere 25 des Gehäuses 2 zusätzlich zu vermeiden, können die Anschlussverbinder 4, 5 mit dem Gehäuse 2, das insbesondere aus Kunststoff besteht, insbesondere ein spritzgegossenes Kunststoffgehäuse ist, beispielsweise stoffschlüssig verbunden werden bzw. sein. Hierdurch kann ein Eindringen von Flüssigkeit bzw. Feuchtigkeit und anderen Medien von außen in das Innere 25 des Gehäuses 2 im Bereich des Übergangs des Gehäuse 2 zu den Anschlussverbindern 4, 5 besonders sicher vermieden werden. Ferner ist es möglich, die beiden Gehäuseteile 20, 21 des Gehäuses 2 nach der fertigen Montage der Anordnung 1 miteinander ebenfalls stoffschlüssig zu verbinden, beispielsweise durch Verschweißen. Somit können beispielsweise zwei Schweißnähte 100, 101, wie in Figur 10 angedeutet, vorgesehen werden, wobei die erste Schweißnaht 100 zwischen den jeweiligen Anschlussverbindern 4 bzw. 5 und dem ersten Gehäuseteil 20 und die zweite Schweißnaht 101 zum Verbinden der beiden Gehäuseteile 20, 21 zwischen diesen vorgesehen wird.

Wie bereits bezüglich Figur 2 erwähnt, wird die Montage in bezüglich der späteren Orientierung der Anordnung umgekehrter Positionierung vorgenommen, so dass der zweite Gehäuseteil 21 in Montagerichtung unten liegt und der erste Gehäuseteil 20, in den die elektronische Komponente 6 und eine eventuelle Platine, auf der diese angeordnet ist, vorgesehen sind in Montagerichtung oben liegt (siehe Figur 2). Durch die Aufnahme der Profilelementenden 31, 32 in den schlitzförmigen Öffnungen 22 in den laschenförmigen, endseitig vorkragenden Abschnitten 23 des ersten Gehäuseteils 20 ist eine definierte Lage bzw. vorgegebene Positionierung des Profilelements 3 in dem Gehäuse 2 möglich. Hierdurch kann ebenfalls eine definierte Positionierung des Profilelements 3 zu der wärmeabgebenden elektronischen Komponente bzw. Leistungselektronikkomponente vorgesehen werden, wie dies beispielsweise den Figuren 3 und 6 bis 9 entnommen werden kann.

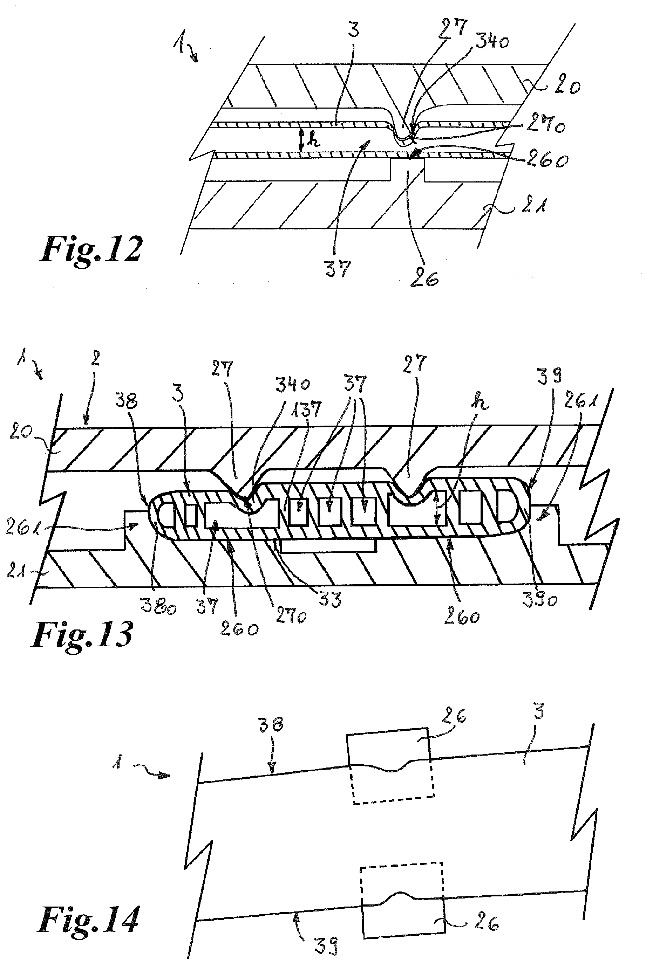

Wie besonders den Figuren 3, 4 und 6 bis 9 entnommen werden kann, ist das Profilelement 3 in dem Gehäuse 2 mechanisch fixiert. Dies erfolgt beispielsweise durch von den Gehäuseteilen 20, 21 nach innen vorstehende Fixierelemente 27, wie sie in Figur 1 bis 4, 6 bis 9, 12 und 13 gezeigt sind, die an einer Außenseite34 des Profilelementes 3 angreifen, anliegen oder in diese eingreifen, was den Figuren 12 und 13 besser entnommen werden kann. Ferner wird das Profilelement 3 in dem Gehäuse durch Vormontage-Klemmelemente 26 seitlich fixiert. Die Vormontage-Klemmelemente 26 sind ebenfalls den Figuren 1 bis 4, 6 bis 9 sowie 12 bis 14 zu entnehmen. Besonders gut sind die Vormontage-Klemmelemente 26 der Figur 2 und der Figur 14 zu entnehmen. Die Vormontage-Klemmelemente 26 sind jeweils paarweise im zweiten Gehäuseteil 21, somit dem Gehäusedeckel, angeordnet und greifen klemmend außenseitig entlang der Längsseiten 38, 39 des Profilelements 3 an diesem an. Wie Figur 13 zu entnehmen ist, umfassen die Vormontage-Klemmelemente 26 jeweils einen Auflageabschnitt 260, auf dem das Profilelement 3 aufliegt, und einen seitlichen Klemmabschnitt 261, der sich seitlich entlang der Längsseiten 38 bzw. 39 des Profilelements 3 klemmend an diesem anlegt. Die Klemmwirkung entsteht jeweils im Zusammenspiel zwischen zwei einander gegenüberliegenden seitlichen Klemmabschnitten 261 zweier Vormontage-Klemmelemente 26, wobei das Profilelement 3 zwischen beiden zwischengefügt ist, wie den Figuren 2 und 13 besonders gut entnommen werden kann. Das Profilelement 3 liegt mit seiner Außenseite 33 dabei auf dem Auflageabschnitt 260 auf. Die seitlichen Klemmabschnitte 261 zweier einander gegenüberliegender Vormontage-Klemmelemente 26 können sich entlang der Längsseiten 38, 39 des Profilelementkörpers 30 des Profilelements 3 in diesen bzw. die dort vorgesehene Außenwand eindrücken, um die klemmende Halterung zu bewirken. Dies ist in Figur 14 angedeutet. Anstelle des klemmenden und hierbei eindrückenden Eingreifens der seitlichen Klemmabschnitte 261 zweier einander gegenüberliegender Vormontage-Klemmelemente 26 an dem Profilelement 3 kann letzteres entlang seinen beiden Längsseiten 38, 39, beispielsweise etwa im Bereich der halben Längserstreckung, mit Einkerbungen oder Prägungen versehen sein, in die die seitlichen Klemmabschnitte 261 der beiden einander gegenüberliegenden Vormontage-Klemmelemente 26 eingreifen können. Diese seitlichen Einprägungen oder Einkerbungen können breiter ausgebildet werden als die seitlichen Klemmabschnitte 261 der einander gegenüberliegenden Vormontage-Klemmelemente 26, so dass ein geringfügiges Verschieben des Profilelements in dessen Längsrichtung auch bei Eingreifen der seitlichen Klemmabschnitte 261 der Vormontage-Klemmelemente 26 in die Einkerbungen oder Einprägungen des Profilelements 3 möglich bleibt. Ein solches Verschieben in Längsrichtung des Profilelements 3 kann beispielsweise bei thermischen Längenänderungen erfolgen oder aufgrund von Fertigungstoleranzen, die hierüber ausgeglichen werden können.

Die Fixierelemente 27 können, wie insbesondere den Figuren 1, 3, 4 sowie 6 bis 9 und 12, 13 entnommen werden kann, beispielsweise stiftförmig oder domförmig mit einer gerundeten Auflagefläche ausgebildet sein. Die gerundete Auflagefläche 270 drückt sich in die Außenwandung 340 des Profilelements 3 ein, wie besonders gut den Figuren 13 entnommen werden kann. Hierdurch ist ein Fixieren des Profilelements im Gehäuse 2 sehr gut möglich, da durch das Vorsehen der Fixierelemente 27 auch ein Toleranzausgleich von Fertigungstoleranzen bezüglich des Profilelements 3 einerseits und des Gehäuses 2 andererseits möglich ist. Durch das Vorsehen der entsprechend gerundeten Auflagefläche 270, die kleiner ist als die Auflagefläche der Auflageabschnitte 260 der Vormontage-Klemmelemente 26, wie dies insbesondere auch den Figuren 12 und 13 entnommen werden kann, kann sichergestellt werden, dass die Fixierelemente 27 sich in die Außenwandung 340 des Profilelements 3 eindrücken und dies nicht durch die Auflageabschnitte 260 der Vormontage-Klemmelemente 26 erfolgt. Durch das Eindrücken der Fixierelemente 27 in die Außenwandung 340 des Profilelements 3 kann auch ein Verschieben des Profilelements 3 in dessen Längsrichtung verhindert werden. Beispielsweise können zumindest zwei Fixierelemente 27 je Seite des Profilelements 3 vorgesehen werden. Dies ist beispielhaft auch Figur 1 zu entnehmen. Dort sind jeweils im Bereich der Profilelementenden 31, 32 auf den laschenförmigen endseitig vorkragenden Abschnitten 23 des ersten Gehäuseteils 20 jeweils zwei Fixierelemente 27 vorgesehen.

Wie Figur 13 besonders gut entnommen werden kann, greifen die Fixierelemente 27 in die Außenwandung 340 des Profilelements 3 in Bereichen ein, in denen im Innern des Profilelements ein jeweiliger innerer Strömungskanal 37 vorgesehen ist. Einerseits kann hierdurch verhindert werden, dass die zwischen den inneren Strömungskanälen angeordneten Stege 137 durch die in die Außenwandung 340 des Profilelements 3 eingreifenden Fixierelemente 27 nicht beschädigt werden. Andererseits kann ebenfalls verhindert werden, dass es die Stege 137 im Innern des Profilelements 3 verhindern, einen Toleranzausgleich vorzunehmen. Wie Figur 13 zu entnehmen, weist das Profilelement 3 in dieser Ausführungsform unterschiedlich breite innere Strömungskanäle 37 auf, wobei die Fixierelemente im Bereich der beiden breitesten inneren Strömungskanäle 37 in die Außenwandung 340 des Profilelements 3 eingreifen. Durch das Vorsehen unterschiedlich breiter innerer Strömungskanäle 37 kann im Wesentlichen sichergestellt werden, dass die Fixierelemente 27 stets entlang deren Erstreckung in die Außenwandung 340 eingreifen. Ferner ist es natürlich auch möglich, die Fixierelemente 27 so im ersten Gehäuseteil 20 anzuordnen, dass in jedem Fall ein Eingreifen in die Außenwandung 340 des Profilelements 3 immer im Bereich eines inneren Strömungskanals 37 von diesem erfolgt.

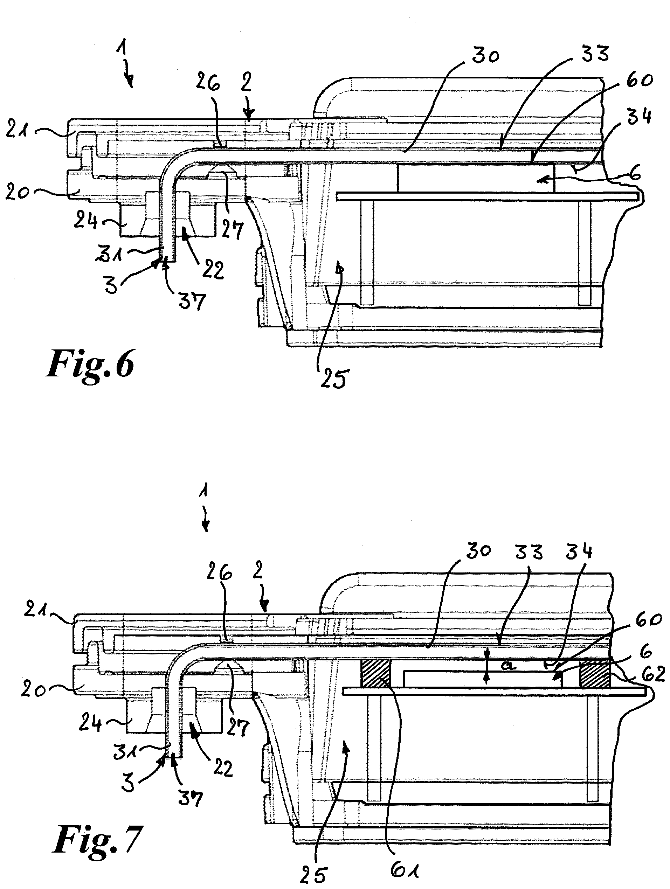

Durch das Vorsehen der Fixierelemente 27 und der Vormontage-Klemmelemente 26 ist eine sehr gute Positions- bzw. Lagefixierung des Profilelements 3 im Innern 25 des Gehäuses 2 möglich. Über die Fixierelemente und die Vormontage-Klemmelemente 26, 27 ist es ferner möglich, eine federnde Lagerung des Profilelements 3 vorzusehen. Zu diesem Zweck können die Fixierelemente 27 und/oder die Vormontage-Klemmelemente 26 z.B. als Federelemente oder Gummielemente ausgebildet sein. Aufgrund von Fertigungstoleranzen ist es möglich, dass der Abstand des Profilelements 3 von der wärmeabgebenden elektronischen Komponente 6 teilweise variiert, gerade auch bei einer Serienfertigung. Der Abstand a zwischen der Oberfläche der wärmeabgebenden elektronischen Komponente 6 und dem Profilelement 3 bzw. dessen zur Komponente 6 gerichteten Außenseite 34, wie er in Figur 3 gezeigt ist, kann somit aufgrund von Fertigungstoleranzen gegebenenfalls variieren. Um jedoch einen gewünschten vorgegebenen Abstand a zwischen dem Profilelement 3 als Wärmetauscher und der wärmeabgebenden elektronischen Komponente 6 einhalten zu können und dadurch einen geringen thermischen Widerstand vorzusehen, kann durch das Profilelement 3 beispielsweise ein mechanischer Druck auf die Wärmequelle in Form der wärmeabgebenden elektronischen Komponente 6 ausgeübt werden, wie in Figur 6 angedeutet. Damit das Profilelement 3 einen (leichten) mechanischen Druck auf die wärmeabgebende Komponente 6 ausüben, sich somit möglichst an der Außenseite 60 der wärmeabgebenden elektronischen Komponente 6 anlegend kann, insbesondere flächendeckend anlegen kann, kann ein Mittel zum Ausüben des Drucks bzw. Bewegungsdrucks vorgesehen werden. Durch das Zusammenwirken der Auflageabschnitte 260 der Vormontage-Klemmelemente 26 und der Fixierelemente 27 kann das Profilelement 3 nahe an die Wärmequelle in Form der wärmeabgebenden elektronischen Komponente 6 gebracht werden. Daher kann die Kombination von Fixierelementen 27 und Vormontage-Klemmelementen 26 insbesondere im Bereich der Hälfte der Gehäuselänge bzw. Profilelementlänge und an dessen Enden angeordnet sein bzw. im Bereich der wärmeabgebenden elektronischen Komponente 6. Über die Eindringtiefe der Fixierelemente 27 kann der Abstand a zwischen den Profilelementen 3 bzw. dessen Außenseite 34 und der wärmeabgebenden elektronischen Komponente 6 eingestellt und entsprechend eingehalten werden. Wie Figur 13 zu entnehmen ist, kann die Eindringtiefe der Fixierelemente 27 in die Außenwandung 340 des Profilelements 3 variiert werden. Die lichte Höhe h des inneren Strömungskanals 37 kann beispielsweise um maximal 50 % durch das Eindrücken der Außenwandung 340 durch die Fixierelemente 27 verringert werden. Beispielsweise kann eine Verringerung im Bereich zwischen 10 und 50 % vorgesehen werden, beispielsweise eine Verringerung um 40 %, 30 %, 20 %, 10 % oder auch um weniger als 10 %.

Wie Figur 13 ferner noch entnommen werden kann, führt ein Einprägen oder Einkerben des Profilelements 3 im Bereich von dessen Längsseiten 38, 39 nicht zu einer maßgeblichen Verringerung des zur Verfügung stehenden Strömungsquerschnitts, insbesondere auch bereits aufgrund der Tatsache, dass die benachbart zu den Längsseitenwandungen 380, 390 angeordneten inneren Strömungskanäle 37 an den Profilelementenden 31, 32 des Profilelements 3 durch insbesondere erste Dichtelemente 7 (siehe Figur 1) oftmals ohnehin verschlossen werden.

Eine alternative Möglichkeit zum Reduzieren des thermischen Widerstandes zum Verbessern des Wärmeübergangs von der wärmeabgebenden elektronischen Komponente 6 an das wärmeaufnehmende Profilelement 3 ist in Figur 7 gezeigt. Hierbei wird ein definierter Abstand zwischen dem Profilelement 3 und der wärmeabgebenden elektronischen Komponente 6 dadurch geschaffen, dass benachbart zu der wärmeabgebenden elektronischen Komponente 6 Abstandshalter 61, 62 vorgesehen sind, an denen sich das Profilelement 3 mit seiner Außenseite 34 anlegt, gegebenenfalls unter Ausüben eines mechanischen Drucks auf die Abstandshalter 61, 62. Da nicht der innere Hohlraum des Gehäuses 2 gekühlt werden soll, sondern durch das Profilelement 3, das vorzugsweise aus Aluminium besteht und flüssigkeitsdurchströmt ist, die von der wärmeabgebenden elektronischen Komponente 6 abgegebene Wärme aufgenommen und aus dem Gehäuseinnern 25 nach außen abtransportiert werden soll, wird das Profilelement 3 in einer definierten Positionierung zu der wärmeabgebenden elektronischen Komponente 6 angeordnet. Durch das Vorsehen der Abstandshalter 61, 62 kann ebenfalls ein gewünschter vorgebbarer Abstand a zwischen Profilelement 3 und der wärmeabgebenden elektronischen Komponente 6 geschaffen werden. Hierdurch ist ebenfalls eine kostengünstige Möglichkeit zum Ausgleich von Fertigungstoleranzen bezüglich des Profilelements 3, jedoch auch zur Aufnahme und Fixierung durch die Fixierelemente 27 und Vormontage-Klemmelemente 26 im Gehäuse 2 möglich. Zum Erzeugen eines mechanischen Drucks auf die Abstandshalter 61, 62 kann auch hier beispielsweise ein Federelement vorgesehen werden, das den entsprechenden Druck auf das Profilelement ausübt.

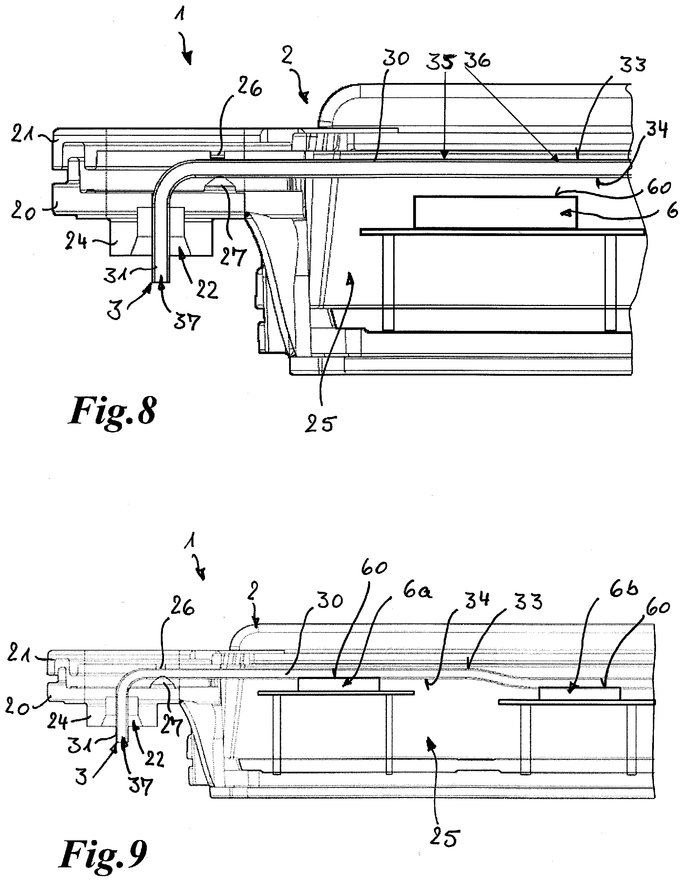

In Figur 8 ist eine Möglichkeit zum Vergrößern der Oberfläche des Profilelements 3 durch Vorsehen von oberflächenvergrößernden Elementen, hier beispielhaft Einkerbungen 35, 36, gezeigt. Anstelle von Einkerbungen 35, 36 können auch Nuten oder andere flächenvergrößernde und/oder in das Innere des Profilelements 3 hineinragende Elemente vorgesehen werden. Diese sind im Bereich der Außenseite 33 des Profilelements 3, somit auf der gegenüberliegenden Seite der wärmeabgebenden elektronischen Komponente 6, bezogen auf das Profilelement 3, angeordnet, allerdings bezüglich der Positionierung in Längsrichtung des Profilelements 3 im Bereich der Wärmequelle, also der wärmeabgebenden elektronischen Komponente 6, wie ebenfalls Figur 8 besonders gut entnommen werden kann. Durch das Vorsehen der Einkerbungen 35, 36 kann nicht nur die wärmeübertragende Fläche vergrößert werden, sondern zugleich auch die Strömung in dem zumindest einen inneren Strömungskanal 37 des Profilelements 3 stärker verwirbelt werden, so dass die Wärmeaufnahme in das Kühlmedium bzw. Kühlmittel, das durch den Flüssigkeitswärmetauscher in Form des Profilelements 3 strömt, noch weiter verbessert werden kann.

Sind innerhalb des Gehäuses 2 mehrere wärmeabgebende elektronische Komponente 6 angeordnet, die unterschiedliche Bauhöhen aufweisen, wie in Figur 9 angedeutet, kann das Profilelement 3 im Bereich seines Profilelementkörpers 30 gebogen bzw., wie hier gezeigt, gekröpft ausgebildet werden. Hierdurch ist eine optimale Anlage des Profilelements 3 mit seiner Außenseite 34 auf der jeweiligen Außenseite 60 der beiden wärmeabgebenden elektronischen Komponenten 6a und 6b im Innern 25 des Gehäuses 2 möglich. Da das Profilelement 3 vorteilhaft aus Aluminium in Form eines Aluminiumextrusionsprofils besteht, lässt es sich gut biegen, so dass eine optimale Anpassung an unterschiedliche Bauhöhen der im Innern 25 des Gehäuses 2 angeordneten wärmeabgebenden elektronischen Komponenten 6 bzw. 6a, 6b möglich ist.

Die Anzahl der inneren Strömungskanäle 37 und von zwischen diesen angeordneten Stegbereichen des Profilelements 3 kann in Abhängigkeit von dessen Höhenstabilität variiert werden. Die Auslegung erfolgt dabei so, dass eine ausreichende Anzahl bzw. Breite von Stegen 137 oder Stegbereichen zwischen den Strömungskanälen und im Vergleich zu deren Durchmesser vorgesehen wird, um einem auf das Profilelement 3 aufgebrachten Druck im Bereich der Herausführung des Profilelements 3 aus dem Gehäuse 2 standhalten zu können. Dort üben die beiden Dichtelemente 7, 8 einen Druck zum Erzielen der gewünschten Abdichtung auf das Profilelement 3 aus. Dieser könnte ansonsten bei einer nicht ausreichenden Anzahl und/oder Breite der Stege 137 bzw. Stegbereiche zwischen bzw. benachbart zu den Strömungskanälen 37 zu einem ungewollten Eindrücken des Profilelements 3 führen.

Ferner kann das Profilelement 3 zumindest doppelt so breit wie hoch sein. Beispielsweise kann die Breitenerstreckung b des Profilelements x-mal so groß wie dessen Höhenerstreckung H sein (siehe Figur 2), wobei x eine ganze oder rationale Zahl sein kann, z.B. 3, 4, 5, 6, 7 oder eine andere natürliche oder rationale Zahl, wie beispielsweise 6,67. Auch hierdurch wird eine ausreichende Stabilität des Profilelements 3 in dessen Höhenerstreckungsrichtung erzielt.

Wie bereits erwähnt, können an die beiden Anschlussverbinder 4, 5 Leitungen zum Zuführen und Abführen von Kühlflüssigkeit bzw. Kühlmittel angeschlossen werden. Es ist somit ein Anschließen der Anordnung 1 an ein Kühlsystem möglich. Ein solches Kühlsystem kann gezielt zum Kühlen des durch die Anordnung 1 bzw. das Profilelement 3 von dieser strömenden Kühlmittels vorgesehen werden, was den Vorteil hat, dass die inneren Strömungskanäle 37 des Profilelements vor einem Zusetzen mit Schwebstoffen, die zu Ablagerungen führen, geschützt werden können. Erfolgt ein Anschluss an beispielsweise ein Kühlsystem eines Fahrzeugs, wie beispielsweise an eine Klimaanlage von diesem, kann es erforderlich sein, zum Vermeiden eines Eintrags von Schwebstoffen, somit zum Verhindern von Ablagerungen in den inneren Strömungskanälen 37 des Profilelements 3 Filterelemente vorzusehen, die Schwebstoffe bzw. Partikel aus dem Kühlsystem abfangen, bevor sie in die inneren Strömungskanäle 37 des Profilelements 3 gelangen und diese verstopfen bzw. zusetzen können.

Durch das endseitige Abwinkeln der Profilelementenden 31, 32 gegenüber dem Profilelement 30 ist eine sichere Abdichtung des Profilelements 3 gegenüber dem Innern 25 des Gehäuses 2 und somit der darin angeordneten zumindest einen wärmeabgebenden elektronischen Komponente 6 bzw. 6a und 6b auch bei Aufbringen eines Drucks in Montagerichtung (siehe Pfeil P1 in Figur 2) von beispielsweise 1 mm möglich. Allerdings kann auch bei Weglassen eines solchen Abwinkelns der Profilelementenden 31, 32, also bei einem etwa gleichmäßig ebenen Profilelement 3 weiterhin eine sichere Abdichtung des Profilelements 2 gegenüber dem Innern 25 des Gehäuses 2 und somit der darin angeordneten zumindest einen wärmeabgebenden elektronischen Komponente 6 bzw. 6a und 6b auch bei Aufbringen eines Drucks in Montagerichtung sichergestellt werden. Ein Eindringen von Feuchtigkeit bzw. Flüssigkeit in das Innere 25 des Gehäuses 2 kann in beiden Ausführungsvarianten somit sicher verhindert werden.

Neben den im Vorstehenden beschriebenen und in den Figuren gezeigten Ausführungsformen von Anordnungen mit Gehäuse, aufnehmend zumindest eine wärmeabgebende elektronische Komponente, wie beispielsweise eine Leistungselektronikkomponente, und mit Kühlsystem zum Kühlen der zumindest einen wärmeabgebenden elektronischen Komponente, wobei die zumindest eine wärmeabgebende elektronische Komponente in dem Gehäuse angeordnet ist, und wobei das Kühlsystem zumindest einen Wärmetauscher umfasst, können noch zahlreiche weitere gebildet werden, insbesondere auch beliebige Kombinationen der genannten Merkmal, wobei der Wärmetauscher ein Flüssigkeitswärmetauscher ist und zumindest ein Profilelement aus zumindest einen wärmeleitfähigen bzw. wärmeleitenden Material umfasst und wobei das zumindest eine Profilelement in dem Gehäuse in einer vorgebbaren Position zu der zumindest einen wärmeabgebenden elektronischen Komponente angeordnet ist.

### Bezugszeichenliste

- 1: Anordnung
- 2: Gehäuse
- 3: Profilelement
- 4: Anschlussverbinder
- 5: Anschlussverbinder
- 6: wärmeabgebende elektronische Komponente
- 6a: wärmeabgebende elektronische Komponente
- 6b: wärmeabgebende elektronische Komponente
- 7: erstes Dichtelement
- 8: zweites Dichtelement
- 9: Stützelement
- 20: erster Gehäuseteil/Grundplatte
- 21: zweiter Gehäuseteil/Gehäusedeckel
- 22: Öffnung
- 23: laschenförmiger endseitig vorkragender Abschnitt
- 24: umlaufender vorkragender Rand
- 25: Inneres von 2
- 26: Vormontage-Klemmelement
- 27: Fixierelement
- 30: Profilelementkörper
- 31: Profilelementende
- 32: Profilelementende
- 33: Außenseite
- 34: Außenseite
- 35: Einkerbung
- 36: Einkerbung
- 37: innerer Strömungskanal
- 38: Längsseite
- 39: Längsseite
- 40: Körperabschnitt
- 50: Körperabschnitt
- 60: Außenseite
- 61: Abstandshalter
- 62: Abstandshalter
- 100: Schweißnaht
- 101: Schweißnaht
- 137: Steg
- 260: Auflageabschnitt
- 261: Seitlicher Klemmabschnitt
- 270: Auflagefläche
- 340: Außenwandung
- 380: Längsseitenwandung
- 390: Längsseitenwandung
- P1: Pfeil/Montagerichtung
- a: Abstand zwischen 3 und 6
- b: Breitenerstreckung von 3
- H: Höhenerstreckung von 3
- h: lichte Höhe von 37

## Patentansprüche

1. Anordnung (1) mit Gehäuse (2) zur Aufnahme zumindest einer wärmeabgebenden elektronischen Komponente (6, 6a, 6b), insbesondere Leistungselektronikkomponente, und mit Kühlsystem zum Kühlen der zumindest einen wärmeabgebenden elektronischen Komponente (6, 6a, 6b), wobei die zumindest eine wärmeabgebende elektronische Komponente (6, 6a, 6b) in dem Gehäuse (2) angeordnet ist, und wobei das Kühlsystem zumindest einen Wärmetauscher umfasst,
**dadurch gekennzeichnet, dass**
der zumindest eine Wärmetauscher ein Flüssigkeitswärmetauscher ist und zumindest ein Profilelement (3) aus zumindest einem wärmeleitenden Material vorgesehen ist, wobei das zumindest eine Profilelement (3) der Flüssigkeitswärmetauscher ist und zumindest zwei Strömungskanäle (37) zum Durchströmen mit Fluid aufweist, und wobei das zumindest eine Profilelement (3) in dem Gehäuse (2) in einer vorgebbaren Position zu der zumindest einen wärmeabgebenden elektronischen Komponente (6, 6a, 6b) angeordnet ist.

2. Anordnung (1) nach Anspruch 1,
**dadurch gekennzeichnet, dass**
das zumindest eine Profilelement (3) in dem Gehäuse (2) federnd gelagert ist.

3. Anordnung (1) nach Anspruch 1 oder 2,
**dadurch gekennzeichnet, dass**
das zumindest eine Profilelement (3) ein Aluminiumprofil, insbesondere Aluminiumextrusionsprofil, ist.

4. Anordnung (1) nach einem der vorstehenden Ansprüche,
**dadurch gekennzeichnet, dass**
das zumindest eine Profilelement (3) auf zumindest einer nicht zur Wärmeübertragung dienenden Außenseite (33) zumindest ein oberflächenvergrößerndes Element, insbesondere Einkerbungen (35, 36), Nuten oder andere flächenvergrößernde und/oder in das Innere des Profilelements (3) hineinragende Elemente, und/oder zumindest eine Nut, Prägung oder Aussparung entlang der Seitenränder oder Seitenwandungen des Profilelements zum Fixieren des Profilelements (3) bei dessen Längenausdehnung aufweist.

5. Anordnung (1) nach einem der vorstehenden Ansprüche,
**dadurch gekennzeichnet, dass**
das zumindest eine Profilelement (3) an der zumindest einen wärmeabgebenden elektronischen Komponente (6, 6a, 6b) anliegend angeordnet ist, wobei durch das zumindest eine Profilelement (3) ein Anpressdruck gegen diese ausgeübt wird.

6. Anordnung (1) nach einem der Ansprüche 1 bis 4,
**dadurch gekennzeichnet, dass**
das zumindest eine Profilelement (3) so an zumindest einem im Bereich der zumindest einen wärmeabgebenden elektronischen Komponente (6, 6a, 6b) angeordneten, einen Abstand (a) zu dieser/diesen schaffenden Abstandshalter (61, 62) anliegend oder an diesem/diesen angreifend angeordnet ist, dass durch das zumindest eine Profilelement (3) ein Anpressdruck gegen den zumindest einen Abstandshalter (61, 62) ausgeübt wird.

7. Anordnung (1) nach einem der vorstehenden Ansprüche,
**dadurch gekennzeichnet, dass**
das zumindest eine Profilelement (3) zur konturnahen Kühlung der zumindest einen wärmeabgebenden elektronischen Komponente (6, 6a, 6b) gebogen, gekröpft oder konturiert ausgebildet ist.

8. Anordnung (1) nach einem der vorstehenden Ansprüche,
**dadurch gekennzeichnet, dass**
das zumindest eine Profilelement (3) gegenüber einem Eindringen von Medien in das Innere (25) des Gehäuses (2) abgedichtet aus dem Gehäuse (2) so herausgeführt ist, dass ein Bewegen des Profilelements (3) in Richtung der wärmeabgebenden elektronischen Komponente (6, 6a, 6b) ermöglicht wird.

9. Anordnung (1) nach einem der vorstehenden Ansprüche,
**dadurch gekennzeichnet, dass**
die Anzahl der inneren Strömungskanäle (37) und von zwischen diesen angeordneten Stegbereichen des zumindest einen Profilelements (3) in Abhängigkeit von dessen Höhenstabilität gewählt ist, wobei das zumindest eine aus dem Gehäuse (2) herausgeführte Profilelement (3) einem auf dieses im Bereich der Herausführung aus dem Gehäuse (2) durch zumindest ein dort vorgesehenes Dichtelement (7, 8) ausgeübten Druck standhält.

10. Anordnung (1) nach einem der vorstehenden Ansprüche,
**dadurch gekennzeichnet, dass**
das zumindest eine Profilelement (3) endseitig in Anschlussverbinder (4, 5) zum Anschließen an zumindest eine Leitung zur Flüssigkeitszu- und -abfuhr, gegenüber dem Innern (25) des Gehäuses (2) abgedichtet aufgenommen ist.

11. Anordnung (1) nach Anspruch 8, 9 oder 10,
**dadurch gekennzeichnet, dass**
eine zweifache Abdichtung der Profilelementenden (31, 32) vorgesehen ist, zumindest ein erstes Dichtelement (31) zur Flüssigkeitsabdichtung gegenüber den Anschlussverbindern (4, 5) und zumindest ein zweites Dichtelement (32) zur Flüssigkeitsabdichtung gegenüber von außen in das Gehäuse (2) eindringenden Medien und zum zusätzlichen Schutz der im Gehäuse (2) angeordneten zumindest einen wärmeabgebenden elektronischen Komponente (6, 6a, 6b) vorgesehen sind.

12. Anordnung (1) nach einem der vorstehenden Ansprüche,
**dadurch gekennzeichnet, dass**
das zumindest eine Profilelement (3) zumindest doppelt so breit wie hoch ist, insbesondere die Breitenerstreckung (b) des zumindest einen Profilelements (3) x-mal so groß wie dessen Höhenerstreckung (h) ist, wobei x eine natürliche oder rationale Zahl größer 2 ist.

13. Anordnung (1) nach einem der vorstehenden Ansprüche,
**dadurch gekennzeichnet, dass**
das Gehäuse (2) ein Kunststoffgehäuse, insbesondere spritzgegossenes Kunststoffgehäuse, insbesondere ein zumindest teilweise leitfähig dotiertes Kunststoffgehäuse, ist.

14. Anordnung (1) nach einem der vorstehenden Ansprüche,
**dadurch gekennzeichnet, dass**
das Gehäuse (2) mehrteilig, insbesondere zweiteilig, ausgebildet und die Gehäuseteile (20, 21) miteinander mediendicht, insbesondere stoffschlüssig, verbunden sind, insbesondere durch Verschweißen stoffschlüssig miteinander verbunden sind.

15. Anordnung (1) nach einem der vorstehenden Ansprüche,
**dadurch gekennzeichnet, dass**
das zumindest eine Profilelement (3) endseitig abgewinkelt ist, insbesondere die Profilelementenden (31, 32) etwa rechtwinklig zur Erstreckung des übrigen Profilelementkörpers (30) angeordnet sind.
